# EUROPEAN PATENT APPLICATION

(11) **EP 4 687 351 A1**
(43) Date of publication of application: **04.02.2026**
(21) Application number: 24192294.7
(22) Date of filing: 01.08.2024
(51) Int. Cl.: H04R 1/08, H04R 1/02, H04R 1/04

(54) **SENSOR FOR A VEHICLE**

(71) Applicant: Valeo Telematik Und Akustik GmbH, 61381 Friedrichsdorf (DE)
(72) Inventor: KLOSE, Michael, 94000 Créteil (FR); RENGANATHAN, Pradeep, 94000 Créteil (FR)
(74) Representative: Delaval, Guillaume Laurent

(57) **Abstract**

The invention relates to a sensor (1) for a vehicle, said sensor (1) comprising :
- an electronic support (10),
- a plurality of electronic components (11) disposed on said electronic support (10),
- a first housing (12),
- a second housing (13), wherein :
- a ring shaped snap joint (14) is arranged on said second housing (13) so as to enable a clipping of said first housing (12) and said second housing (13) together.

## Description

### FIELD OF THE INVENTION

The present invention relates to a sensor for a vehicle. Such sensor, may be used, but not exclusively, in the automotive domain.

### BACKGROUND OF THE INVENTION

In the automotive domain, a sensor for a vehicle, well-known by the person skilled in the art, comprises:
- an electronic support,
- a plurality of electronic components disposed on said electronic support,
- a first housing,
- a second housing.

The sensor is used at the exterior of the vehicle. Such a sensor is for example a MEM capsule that is configured to detect sound frequency coming from emergency vehicles. It is mounted partly outside the vehicle.

The first housing and the second housing are fixed and sealed altogether by means of glueing their junction.

One problem of this prior art is that for the external use case, the sensor needs to be very robust against environmental conditions. In particular, it has to withstand being submerged in hot and cold fluids for testing conditions and to address weather conditions and to withstand an ingress protection of IP6K9K. Unfortunately, the glueing can't reach the IP6K9K ingress protection.

It is an object of the invention to provide a sensor for a vehicle, which resolves the problem above-stated.

### SUMMARY OF THE INVENTION

To this end, it is provided a sensor for a vehicle, said sensor comprising :
- an electronic support,
- a plurality of electronic components disposed on said electronic support,
- a first housing,
- a second housing, wherein :
- a ring shaped snap joint is arranged on said second housing so as to enable a clipping of said first housing and said second housing together.

As we will see in further details, thanks to the ring shaped snap joint, there is no need of using some glue to assemble the first housing and the second housing together. Moreover, the ring shaped snap joint enables a tight clipping between the first housing and the second housing so that the sensor can withstand an ingress protection of IP6K9K : it means that it withstands being submerged in hot and cold fluids. Hence, the sensor is now watertight and submergible.

According to non-limitative embodiments of the invention, the sensor for a vehicle further comprises the following characteristics.

In a non-limitative embodiment, said ring shaped snap joint is arranged all around the second housing of which it is part of.

In a non-limitative embodiment, said sensor further comprises at least one acoustic neutral transparent membrane.

In a non-limitative embodiment, said sensor further comprises at least one cap that is configured to prevent direct water entries into the sensor.

In a non-limitative embodiment, said first housing further comprises at least one recess that is configured to receive said at least one cap.

In a non-limitative embodiment, said sensor further comprises a venting element. The venting element comprises a venting hole.

In a non-limitative embodiment, said sensor further comprises at least one internal support boss.

In a non-limitative embodiment, said first housing is removable or not removable.

In a non-limitative embodiment, when said first housing is not removable, said ring shaped snap joint has a single side tapered, and when said first housing is removable, said ring shaped snap joint has a double side tapered.

In a non-limitative embodiment, said second housing is more rigid than the first housing. The first housing is flexible.

In a non-limitative embodiment, said first housing comprises a groove that is configured to be in contact with said ring shaped snap joint when said first housing and said second housing are clipped together. In particular, the groove fits the ring shaped snap joint.

In a non-limitative embodiment, said ring shaped snap joint is male and said groove is female.

In a non-limitative embodiment, said first housing possesses a base with an internal surface that is a honeycomb structure.

In a non-limitative embodiment, said sensor is a MEM device.

In a non-limitative embodiment, said MEM device is a microphone assembly

In a non-limitative embodiment, said venting element is arranged in the second housing.

In a non-limitative embodiment, said internal support boss is part of the second housing.

In a non-limitative embodiment, the recess has a hole that is configured to be positioned in regards with the acoustic neutral transparent membrane when the sensor is assembled.

In a non-limitative embodiment, the recess comprises a flat face conere with said hole.

### BRIEF DESCRIPTION OF THE DRAWINGS

Some embodiments of methods and/or system in accordance with embodiments of the present invention are now described, by way of example only, and with reference to the accompanying drawings, in which:
Figure 1 is an assembled view in perspective of a sensor for a vehicle according to a non-limitative embodiment of the invention, said sensor comprising an electronic support, a plurality of electronic components, a first housing, a second housing, and a ring shaped snap joint,
Figure 2 is an exploded view in perspective of the sensor of figure 1,
Figure 3 is a zoom on a sectional view of the sensor of figure 1,
Figure 4a is a perspective view of a recess of the first housing of the sensor of figure 1,
Figure 4b is a sectional view of the recess of figure 4a,
Figure 5a is a bottom view the first housing of the sensor of figure 1,
Figure 5b is a top view the first housing of the sensor of figure 1,
Figure 6 is a sectional view of a wall of the first housing of figure 1, said wall comprising a groove according to a first non-limitative variant of a non-limitative embodiment,
Figure 7 is a sectional view of a wall of the first housing of figure 1, said wall comprising a groove according to a second non-limitative variant of a non-limitative embodiment,
Figure 8 illustrates a top view the second housing of the sensor of figure 1,
Figure 9a is a zoom in perspective of a wall of the second housing of figure 8, said wall comprising a ring shaped snap joint according to a first non-limitative variant of a non-limitative embodiment,
Figure 9b is a sectional view of part of the wall of figure 9a with the ring shaped snap joint,
Figure 10a is a zoom in perspective of a wall of the second housing of figure 8, said wall comprising a ring shaped snap joint according to a first non-limitative variant of a non-limitative embodiment,
Figure 10b is a sectional view of part of the wall of figure 10a with the ring shaped snap joint,
Figure 11 is a perspective view of a cap of the sensor 1.

### DESCRIPTION OF EMBODIMENTS OF THE INVENTION

In the following description, well-known functions or constructions by the person skilled in the art are not described in detail since they would obscure the invention in unnecessary detail.

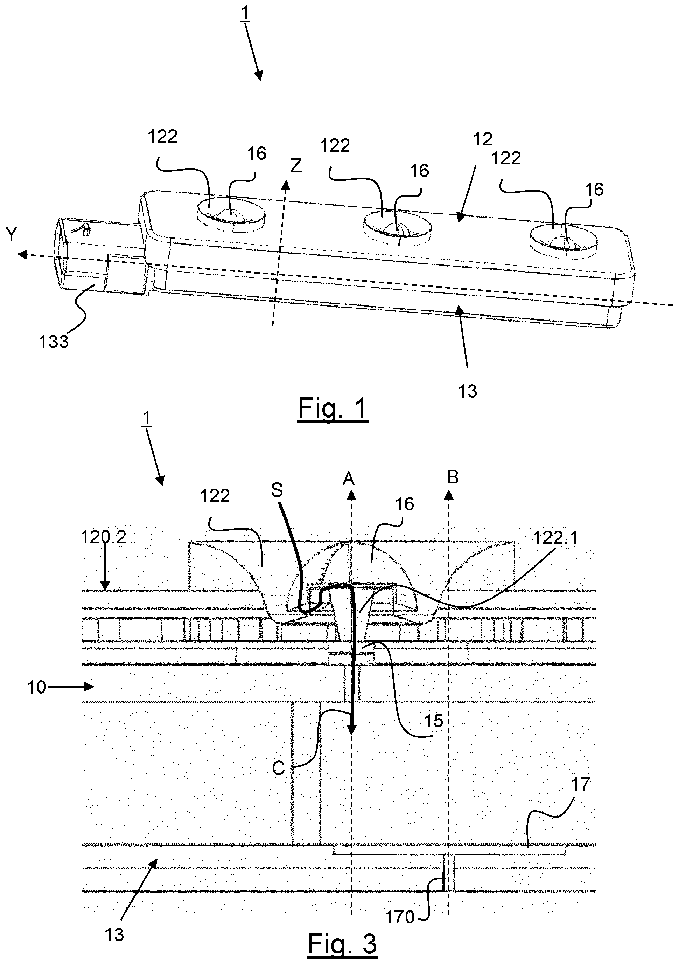

The present invention relates to a sensor 1 for a vehicle, said sensor 1 being described in reference to figures 1 to 11. In a non-limitative embodiment, the vehicle is a motor vehicle. In non-limitative variants of embodiment, the motor vehicle has a combustion engine, an electric engine, or a hybrid engine.

In a non-limitative embodiment, the sensor is a micro-electromechanical device, referred to as a MEM device. In a non-limitative variant of embodiment, the MEM device is a microphone assembly. This non-limitative variant of embodiment is taken as a non-limitative example in the following.

In a non-limitative embodiment, the sensor 1 is mounted near the number plate of the vehicle. In a non-limitative embodiment, the sensor 1 is installed in the vehicle so as to capture the sounds coming from outside the vehicle, such as in a non-limitative example the sounds of sirens of emergency vehicles that are approaching the vehicle. In the following, this non-limitative example of application is taken.

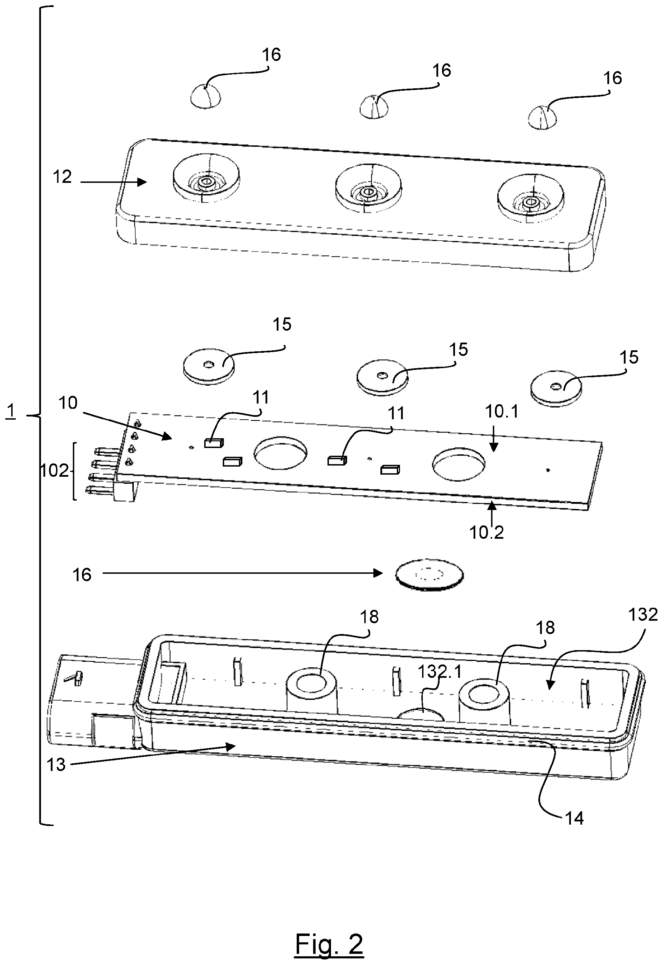

As illustrated in figures 1 and 2, the sensor 1 comprises :
- an electronic support 10 (illustrated in figure 2),
- a plurality of electronic components 11 (illustrated in figure 2) disposed on the electronic support 10,
- a first housing 12 (illustrated in figures 1 and 2),
- a second housing 13 (illustrated in figures 1 and 2),
- a ring shaped snape joint 14 (illustrated in figure 2).

In the following, when speaking of both the first housing 12 and the second housing 13, one will also be referred to as housings 12, 13.

The sensor 1 extends longitudinally along a longitudinal axis Y (illustrated in figure 1), and laterally along a lateral axis Z (illustrated in figure 1) which is perpendicular to the longitudinal axis Y.

The first housing 12 is in a non-limitative embodiment exposed to the direct open environment of the vehicle, while the rest is behind some panels of the vehicle when the sensor 1 is installed in the vehicle.

In a non-limitative embodiment, the sensor 1 further comprises at least one acoustic neutral transparent membrane 15 (illustrated in figure 2 and described later).

In a non-limitative embodiment, the sensor 1 further comprises at least one cap 16 (illustrated in figure 2 and described later).

In a non-limitative embodiment, the sensor 1 further comprises a venting element 17 (illustrated in figure 2 and described later).

In a non-limitative embodiment, the sensor 1 further comprises at least one internal support boss 18 (illustrated in figure 2 and described later).

These different elements of the sensor 1 are described in details hereinafter.

### Electronic support 10:

The electronic support 10 is illustrated in figure 2 and figure 3.

The electronic support 10 is configured to support the electronic components 11. It has two sides 10.1 and 10.2 opposed to each other.

In a non-limitative embodiment, the electronic support 10 is a printed circuit board assembly also referred to as PCBA.

The electronic support 10 is configured to be disposed in a compartment 132 (illustrated in figure 2) of the second housing 13.

The electronic support 10 comprises connection pins 102 (illustrated in figure 2) for power supply and for signal transmission to an electronic unit control (not illustrated) of the vehicle.

### Electronic components 11

The electronic components 11 are illustrated in figure 2.

As illustrated in figure 2, they are placed on the electronic support 10. In a non-limitative embodiment illustrated, they are disposed on one side 10.1 of the electronic support 10. In another non-limitative embodiment not illustrated, they are disposed on both sides 10.1, 10.2.

In a non-limitative embodiment, at least one electronic component 11 is configured to receive sound waves S that are acoustic signals coming through the acoustic neutral transparent membrane(s) 15, into electrical signals and transmit them to an electronic control unit (not illustrated) of the vehicle. This least one electronic component 11 is called capsule. In the case of the emergency vehicle application, the electronic control unit is configured to send a warning signal (visual message, a vocal sound in non-limitative examples) via an interface human machine to a driver of the vehicle to inform him/her that an emergency vehicle is approaching. Hence, the emergency vehicles are detected.

### First housing 12:

The first housing 12 is illustrated in figures 1 to 7.

In a non-limitative embodiment, the first housing 12 is of a plastic material. It is a light material with a reduced cost.

The first housing 12 is configured to protect the electronic support 10, the electronic components 11 and the acoustic neutral transparent membrane 15 in particular from water splashes coming from high pressure water. To this end, the first housing 12 is configured to be sealed with the second housing 13.

The first housing 12 cooperates with the second housing 13 to close the compartment 132 of the second housing 13 by means of the ring shaped snap joint 14. Thus, the compartment 132 of the second housing 13 fits into the first housing 12.

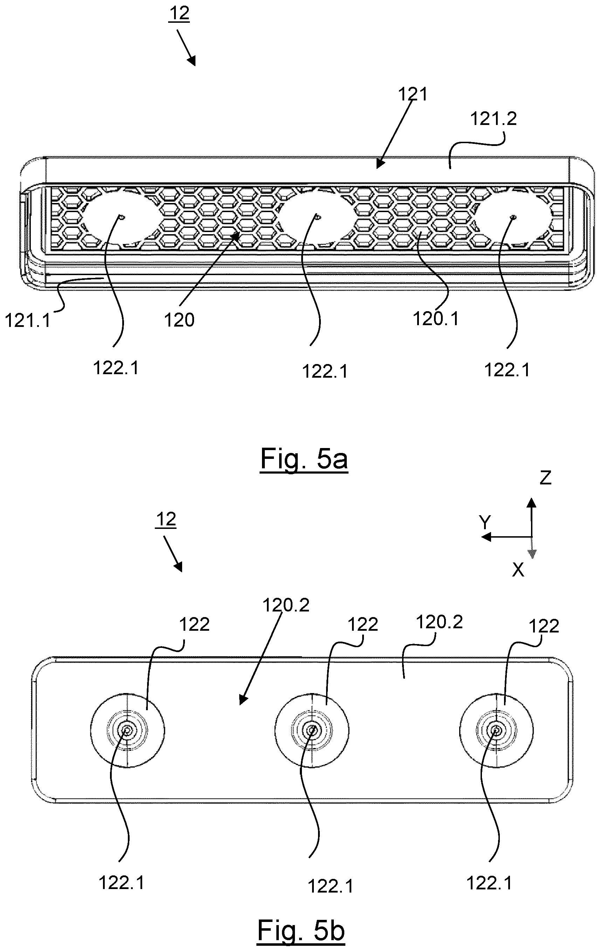

The first housing 12 comprises a base 120 (illustrated in figures 5a and 5b) and a wall 121 (illustrated in figure 5a) that extends from the base 120 and goes all around the perimeter of the base 120. The base 120 has an internal surface 120.1 (illustrated in figure 5a) and an external surface 120.2 (illustrated in figure 5b). The wall 121 has and inside flank 121.1 (illustrated in figure 5a) and an outside flank 121.2 (illustrated in figure 5a).

In a non-limitative embodiment illustrated in figure 5a, the base 120 has an internal surface 120.1 that is a honeycomb structure. It provides stiffness to the center region of the first housing 12. It avoids the center region of the first housing 12 to bend when doing the assembly with the second housing 13.

The first housing 12 comprises a groove 121.3 that is configured to be in contact with the ring shaped snap joint 14 that is arranged on the second housing 13 when the first housing 12 is assembled with the second housing 13. The groove 121.3 is a female groove 121.3.

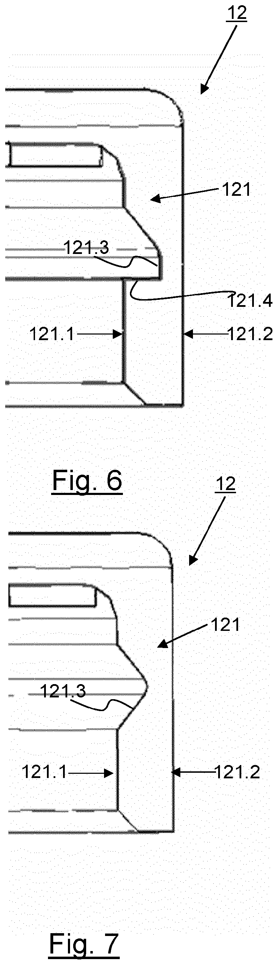

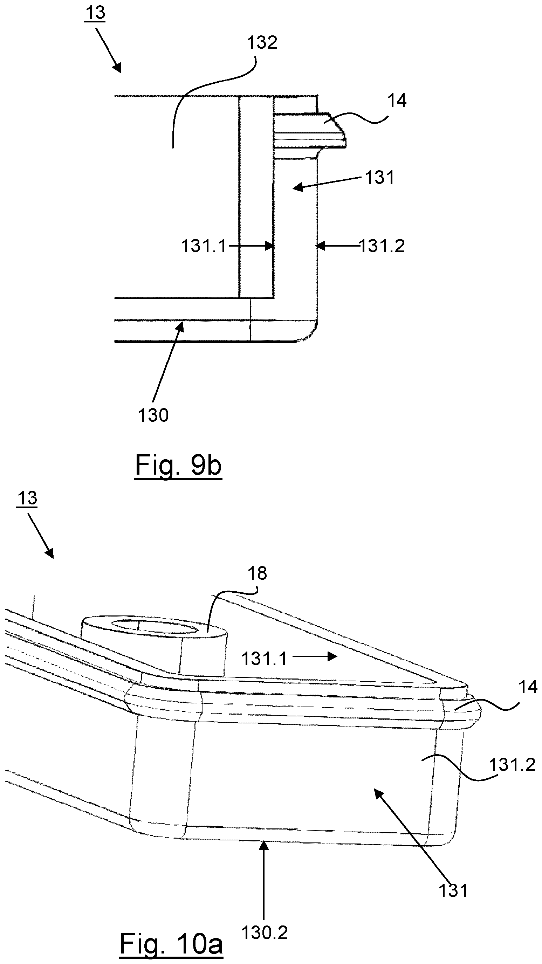

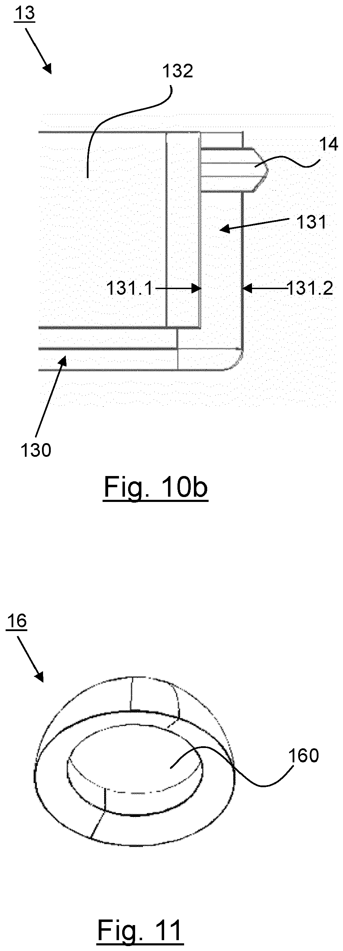

The groove 121.3 illustrated in figures 6 and 7, is arranged on the inside flank 121.1 of the wall 121 of the first housing 12. The groove 121.3 fits the ring shaped snap joint 14 of the second housing 13 illustrated respectively in figures 9b and 10b. The groove 121.3 goes all around the inside flank 121.1.

The contact between the groove 121.3 of the wall 121 of the first housing 12 and the ring shaped snap joint 14 provides a sealing that protects the inside area of the compartment 132 and thus the electronic support 10 and the electronic components 11. As, the groove 121.3 goes all around the inside flank 121.1 and is in contact with the ring shaped snap joint 14 all around, the sealing is all around the first housing 12 and the second housing 13.

In a non-limitative embodiment, the first housing 12 is made of a flexible material. In a non-limitative variant of embodiment, it is made of silicon. It enhanced the tight contact between the inside flank 121.1 of the wall 121 of the first housing 12 and the ring shaped snap joint 14.

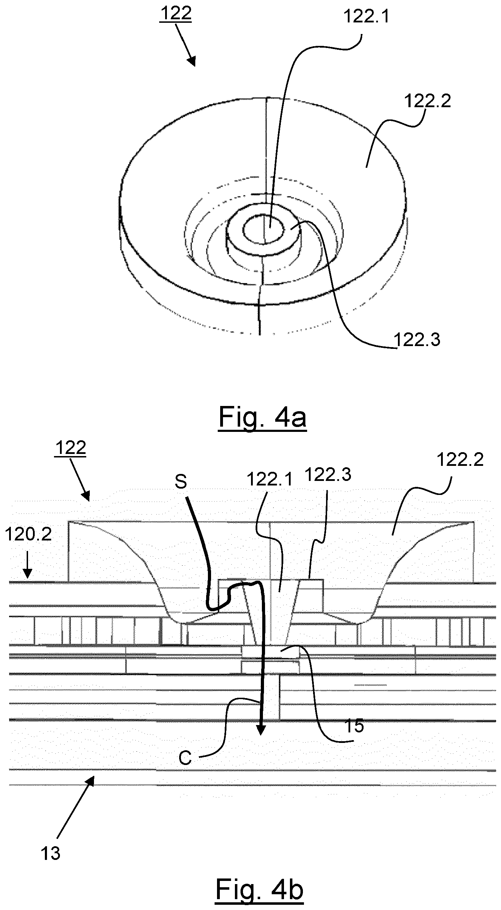

The first housing 12 comprises at least one recess 122 illustrated in figures 4a and 4b. Said at least one recess 122 is disposed on the external surface 120.2 of the base 120 of the first housing 12 as illustrated in figure 3 and 4a. As illustrated in figures 1 and 5b, in a non-limitative embodiment, the first housing 12 comprises three recesses 122.

The recess 122 receives a cap 16 illustrated in figure 11. As illustrated in figure 1, in a non-limitative embodiment, there are three caps 16 that are disposed in three recesses 122.

As illustrated in figure 4a and 4b, the recess 122 has a conical form with curve features 122.2. This conical shape has better acoustical performance than a straight form.

As illustrated in figure 3, the recess 122 comprises a flat face conere 122.3 that is configured to support a cap 16 that is described later in the following.

The flat face conere 122.3 enables to create a corridor for the sound waves S to path through. The corridor is illustrated partly by the arrow referenced C.

As illustrated in figure 3, the flat face conere 122.3 has a hole 122.1 (illustrated in figure 3 to 5b) for the sound waves S to pass through. The hole 122.1 permits the sound waves S to enter in the compartment 132 of the sensor 1 along the corridor C. In a non-limitative embodiment, the hole 122.1 is in the form of a funnel. It offers a path for the sound waves S that facilitates them to enter into the inside of the sensor 1.

As illustrated in figure 3, the recess 122 with the hole 122.1 is positioned in regards with the acoustic neutral transparent membrane 15 (described later in the following) when the sensor 1 is assembled. It is coaxially arranged around substantially the same vertical axis A of the acoustic neutral transparent membrane 15 when all the elements of the sensor 1 are assembled. It permits the sound waves S to reach directly the acoustic neutral transparent membrane 15 via said hole 122.1.

In a first non-limitative embodiment illustrated in figure 6, the first housing 12 is a non-removable housing. It achieves high retention force against internal overpressure. In this case, the first housing 12 comprises a groove 121.3 on the inside flank 121.1 of the wall 121 that has a single side tapered.

In a second non-limitative embodiment illustrated in figure 7, the first housing 12 is a removable housing. It permits easier assembly and access. In this case, in a first non-limitative variant of embodiment illustrated in figure 7, the first housing 12 comprises a groove 121.3 on the inside flank 121.1 of the wall 121 that has a double side tapered.

### Second housing 13:

The second housing 13 is illustrated in figures 1 to 3 and 8 to 10b.

In a non-limitative embodiment, the second housing 13 is of a plastic material. It is a light material with a reduced cost.

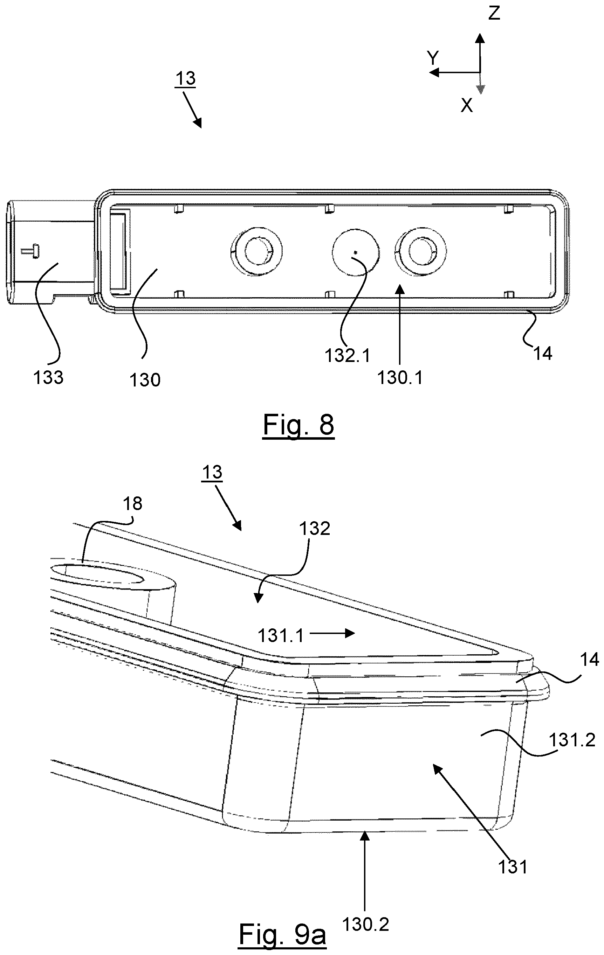

In a non-limitative embodiment, the second housing 13 is configured to receive the electronic support 10 and the electronic components 11. As illustrated in figure 8 and 9a, it is composed of a base 130 and a wall 131 that extends from the base 130 and goes all around the perimeter of the base 130. The whole forms a compartment 132 (illustrated in figures 9a to 10b) that is configured to house the electronic support 10 and the electronic components 11. The base 130 has an internal surface 130.1 (illustrated in figure 8) and an external surface 130.2 (illustrated in figure 9a and 10a). The wall 131 has an inside flank 131.1 and an outside flank 131.2 (illustrated in figure 9a and 10a).

As illustrated in figures 8 to 10b, in a first non-limitative embodiment, the second housing 13 comprises the ring shaped snap joint 14 which is arranged on the outside flank 131.2 of the wall 131. In this case, the ring shaped snap joint 14 is in contact with the inside flank 121.1 of the wall 121 of the first housing 12 when the second housing 13 is assembled with the first housing 12. In particular, it is in contact with the groove 121.3 of the wall 121 mentioned before. The contact between the ring shaped snap joint 14 and the groove 121.3 provides a sealing that protects the inside area of compartment 132 and thus the electronic support 10 and the electronic components 11.

In a first non-limitative embodiment illustrated in figures 9a and 9b, the ring shaped snap joint 14 has a single side tapered. It prevents the first housing 12 to be detached from the second housing 13 after assembly.

In a second non-limitative embodiment illustrated in figures 10a and 10b, the ring shaped snap joint 14 has a double side tapered. It allows the first housing 12 to be detached from the second housing 13 after assembly.

In a non-limitative embodiment, the second housing 13 further comprises an electrical connector 133 (illustrated in figure 8). It permits connecting the connection pins 102 of the electronic support 10 to a power supply (not illustrated) and to the electronic control unit of the vehicle for signal transmission.

### Ring shaped snap joint 14

The ring shaped snap joint 14 is illustrated in figures 2, and 8 to 10b. It is a male ring shaped snap joint 14 that is configured to fit the female groove 121.3.

As described before, the ring shaped snap joint 14 is arranged on the second housing so as to enable a clipping of said first housing 12 and said second housing 13 together. Thanks to the ring shaped snap joint 14, the first housing 12 and the second housing 13 are clipped together in one process step and provide a higher pulling force than a clip on force.

The ring shaped snap joint 14 is configured to be in contact with a groove 121.3 that is arranged on the first housing 12 when said first housing 12 and said second housing 13 are clipped together.

In a non-limitative embodiment, the second housing 13 is more rigid than the first housing 12, and the first housing 12 is flexible so as to facilitate the assembly of both housings 12, 13. In a non-limitative embodiment, the ring shaped snap joint 14 is arranged on the second housing 13 that is more rigid and not on the flexible one. The second housing 13 is rigid so that it can house the electronic support 10 and the electronic components 11. The ring snap joint 14 can't be arranged on the first housing 12 that is too flexible for it.

In a non-limitative embodiment, the second housing 13 that is more rigid is of material PC (Polycarbonate) and ABS (Acrylonitrile Butadiene Styrene). In a non-limitative embodiment, the first housing 12 that is less rigid is of material PE (Polyethylene) or PP (Polypropylene).

The ring shaped snap joint 14 is arranged all around the second housing 13. In particular, it is arranged on the external peripheral of the wall 131 of the second housing 13, hence on the outside flank 131.2 of the wall 131. The first housing 12 comprises the groove 121.3 that fits the ring shaped snap joint 14 as mentioned before.

As the ring shaped snap joint 14 is arranged all around the second housing 13, it provides a higher pulling force than local clips on force. The ring shaped snap joint 14 has an annular form. Therefore, the clipping is an annular clipping.

As the ring shaped snap joint 14 is integrated in the second housing 13, the process of manufacturing is faster as it is molded at the same time as the second housing 13 it is part of.

### Acoustic neutral transparent membrane 15

The acoustic neutral transparent membrane 15 is illustrated in figures 2, 3 and 4b. It is neutral, because all the sound waves S go through this acoustic neutral transparent membrane 15. It is transparent, because all the sound waves S are not affected when they pass through this acoustic neutral transparent membrane 15 and propagate to the electronic component 11 (called capsule) that will receive them and convert them into an electrical signal.

In a non-limitative embodiment, the sensor 1 comprises at least one acoustic neutral transparent membrane 15. It applies especially when the sensor 1 is a microphone assembly. In a non-limitative example illustrated in figures 2, 3 and 4b, it comprises 3 acoustic neutral transparent membranes 15.

The acoustic neutral transparent membrane 15 is configured to let the sound waves S coming from the exterior of the vehicle that have entered through the recess(es) 122 pass through, said sound waves S thus reaching the electronic component 11 that will convert them into an electrical signal as above-mentioned.

As illustrated in figure 3, the acoustic neutral transparent membrane 15 is configured to be in front of a hole 122.1 of a recess 122 of the first housing 12. The acoustic neutral transparent membrane 15 is disposed substantially coaxially with this hole 122.1 of the first housing 12 so that the sound waves S can reach directly the acoustic neutral transparent membrane 15 through said hole 122.1. In other words, the center of the hole 122.1 is substantially collinear with the center of the acoustic neutral transparent membrane 15. The hole 122.1 and the acoustic neutral transparent membrane 15 are both arranged coaxially around the same axis A, but on two different plans which are substantially parallel to each other.

In a non-limitative embodiment, the acoustic neutral transparent membrane 15 is water repelling. So it is not impaired by water that could flow along the wall 121 of the first housing 12 and reach the acoustic neutral transparent membrane 15.

### Cap 16

The cap 16 is illustrated in figure 1, 2, 3 and 11.

In a non-limitative embodiment, the sensor 1 further comprises at least one cap 16. In a non-limitative variant of embodiment, it comprises a plurality of caps 16. In a non-limitative example illustrated on the figures, it comprises three caps 16.

The cap 16 is configured to prevent direct water entries into the sensor 1 and protects the acoustic neutral transparent membrane 15. By this way, it enables a better acoustical performance.

In a non-limitative embodiment, there are as many caps 16 than there are acoustic neutral transparent membranes 15.

The cap 16 is disposed in a recess 122 (above-mentioned) of the first housing 12. In order for the sound waves S to reach the corresponding acoustic neutral transparent membrane 15, the cap 16 is disposed in particular on the flat face conere 122.3 of the recess 122 so as to let a corridor for the sound waves S to path through.

As illustrated in figure 11, the cap 16 is in the form of a half sphere with a cavity 160. The cavity 160 is in contact with the flat face conere 122.3 of the recess 122 when the cap 16 is disposed in the recess 122.

### Venting element 17

The venting element 17 is illustrated in figures 1 and 3.

In a non-limitative embodiment, the sensor 1 further comprises a venting element 17 (also called pressure membrane 17 or pressure vent 17) with a venting hole 170.

The venting element 17 allows to keep the internal air pressure to the level of the atmospheric pressure. It allows the air to go through the sensor 1 but it does stop liquids. It prevents water splashes and dust entry. It is configured to release the heat or pressure that is inside the sensor 1 when it is assembled. It allows the heat or pressure to escape outside the sensor 1. The venting element 17 is configured to continuously equalize the pressure. Constant pressure equalization helps in preventing condensation which can corrode and damage the electrical components. Hence, the venting element 17 permits to prevent overpressure in the sensor 1.

It is to be noted that if the sensor 1 is cold, as soon as it is submerged into hot liquids, the internal air pressure is increased and it is equalized through the venting element 17. On the other hand, if the sensor 1 is hot, as soon as it is submerged in cold liquids, the internal pressure is decreased causing a higher outer pressure on the less rigid housing 12 and so causing a higher mechanical pressure between both housings 12, 13. It even increases the sealing effect to prevent the liquid from getting into the sensor 1. In normal use cases, the sensor 1 is only submerged temporarily. As soon as it is back in air again, the pressure difference between inside and outside of the sensor 1 is vented by the venting element 17.

In a non-limitative embodiment, the venting element 17 is made of PTFE material (Polytetrafluoroethylene).

The venting element 17 is configured to be disposed in the second housing 13 as illustrated in figure 3. In particular it is placed in a venting hole 132.1 (illustrated in figure 8) of the compartment 132 of the second housing 13 intended for this purpose.

As illustrated in figure 3, the venting element 17 is disposed at one side of the electronic support 10 that is arranged opposite to the side where the acoustic neutral transparent membrane(s) 15. In the non-limitative illustrated example, it is disposed along an axis B that is parallel to the axis A of the acoustic neutral transparent membrane(s) 15. In another non-limitative example (not-illustrated) it could be aligned with an acoustic neutral transparent membrane 15 along the same axis.

### Internal support boss 18

The internal support boss 18 is illustrated in figures 2, 9a and 10a.

The sensor 1 further comprises at least one internal support boss 18. In a non-limitative embodiment, the sensor 1 comprises a plurality of internal support bosses 18. In a non-limitative example, it comprises two internal support bosses 18.

The internal support boss 18 also called internal stand 18 prevents a deflection in the center of the first housing 12 when both housings 12, 13 are assembled together by clipping. It limits a deformation of the softer first housing 12 towards the interior of the second housing 13 that is more rigid.

In a non-limitative embodiment, the internal support boss 18 is part of the second housing 13. It arises from the base 130 of the second housing 13 and extends from said base 130 to the base 120 of first housing 12. The internal support boss 15 extends vertically from the base 130 of the second housing 13 along the lateral axis Z. As it extends from the base 130 of the second housing 13 to the base 120 (in particular to the internal surface 120.1) of the first housing 12, the internal support boss 15 prevents a deformation of the first housing 12 towards the interior of the second housing 13. Hence, it gives internal support because more deflection takes place on the center regions.

In a non-limitative embodiment, the internal support boss 18 is molded as a whole when the second housing 13 is molded.

It is to be understood that the present invention is not limited to the aforementioned embodiments and variations and modifications may be made without departing from the scope of the invention. All statements herein reciting principles, aspects, and embodiments of the invention, as well as specific examples thereof, are intended to encompass equivalents thereof. In this respect, the following remarks are made. Hence, in non-limitative embodiments, the sensor is used in other applications different from the emergency vehicle application, for voice control for park assist, or opening the vehicle doors or trunk. Hence, in a non-limitative embodiment, the sensor 1 comprises a plurality of venting elements 17. Hence, in another non-limitative embodiment, the sensor 1 is installed so as to capture sound coming from the inside the vehicle.

Hence, some embodiments of the invention may comprise one or a plurality of the following advantages:
- it provides a very efficient sealing between the first housing 12 and the second housing 13 as it provides a watertight and submergible sensor 1; thus, it provides a sensor 1 that withstands the ingress protection of IP6K9K,
- it provides a sealing of both first housing 12 and second housing 13 in one process step of clipping,
- it simplify the assembly process and reduce the time assembly,
- it reduces the number of parts of the sensor 1, the cost and the assembly cycle time compared to a prior art that uses a plurality of clipping elements comprising hooks and eyes that cooperate together, and that uses an additional flexible sealing ring in a rubber silicone to keep the connection between both housings,
- it avoids using a laser welding process to assemble both the first housing 12 and the second housing 13, said laser welding process being costly,
- it avoids using a gluing process to assemble both the first housing 12 and the second housing 13 at their junction, said gluing process which can't fulfill the ingress protection of IP6K9K.
- it reduces the cost of the sensor 1,
- it provides a sensor that is on the one side acoustically "open" and on the other side very robust against environmental conditions,
- it reduces the used material and number of used parts.

## Claims

1. Sensor (1) for a vehicle, said sensor (1) comprising :
- an electronic support (10),
- a plurality of electronic components (11) disposed on said electronic support (10),
- a first housing (12),
- a second housing (13), wherein :
- a ring shaped snap joint (14) is arranged on said second housing (13) so as to enable a clipping of said first housing (12) and said second housing (13) together.

2. Sensor (1) according to claim 1, wherein said ring shaped snap joint (14) is arranged all around the second housing (13) of which it is part of.

3. Sensor (1) according to any of the preceding claims, wherein said sensor (1) further comprises at least one acoustic neutral transparent membrane (15).

4. Sensor (1) according to any of the preceding claims, wherein said sensor (1) further comprises at least one cap (16) that is configured to prevent direct water entries into the sensor (1).

5. Sensor (1) according to the preceding claim, wherein said first housing (12) further comprises at least one recess (122) that is configured to receive said at least one cap (16).

6. Sensor (1) according to any of the preceding claims, wherein said sensor (1) further comprises a venting element (17).

7. Sensor (1) according to any of the preceding claims, wherein said sensor (1) further comprises at least one internal support boss (18).

8. Sensor (1) according to any of the preceding claims, wherein said first housing (12) is removable or not removable.

9. Sensor (1) according to the preceding claim, wherein when said first housing (12) is not removable, said ring shaped snap joint (14) has a single side tapered and when said first housing (12) is removable, said ring shaped snap joint (14) has a double side tapered.

10. Sensor (1) according to any of the preceding claims, wherein said second housing (13) is more rigid than the first housing (12).

11. Sensor (1) according to any of the preceding claims, wherein said first housing (12) comprises a groove (121.3) that is configured to be in contact with said ring shaped snap joint (14) when said first housing (12) and said second housing (13) are clipped together.

12. Sensor (1) according to the preceding claim, wherein said ring shaped snap joint (14) is male and said groove (121.3) is female.

13. Sensor (1) according to any of the preceding claims, wherein said first housing (12) possesses a base (120) with an internal surface (120.1) that is a honeycomb structure.

14. Sensor (1) according to any of the preceding claims, wherein said sensor is a MEM device.

15. Sensor (1) according to any of the preceding claims, wherein said MEM device is a microphone assembly.
